# EUROPÄISCHE PATENTSCHRIFT

(11) **EP 2 210 341 B1**
(45) Veröffentlichungstag und Bekanntmachung des Hinweises auf die Patenterteilung: **26.02.2020**
(21) Anmeldenummer: 08849336.6
(22) Anmeldetag: 16.10.2008
(51) Int. Cl.: H03K 17/96

(54) **ELEKTROGERÄTSCHALTVORRICHTUNG**
ELECTRIC APPLIANCE SWITCHING DEVICE
DISPOSITIF DE COMMUTATION D'APPAREIL ÉLECTRIQUE

(30) Priorität: 12.11.2007 DE 102007053820
(43) Veröffentlichungstag der Anmeldung: 28.07.2010
(73) Patentinhaber: BSH Hausgeräte GmbH, 81739 München (DE)
(72) Erfinder: HAS, Uwe, 84579 Unterneukirchen (DE)
(86) Internationale Anmeldenummer: PCT/EP2008/063985
(87) Internationale Veröffentlichungsnummer: WO 2009/062807

(56) Entgegenhaltungen:
- EP-A- 0 512 124
- EP-A- 1 750 373
- EP-A- 1 788 367
- DE-A1- 19 811 372
- DE-A1-102004 035 444
- US-A- 3 940 637
- US-A1- 2007 182 594

## Beschreibung

Die Erfindung geht aus von einer Elektrogerätschaltvorrichtung nach dem Oberbegriff des Anspruchs 1.

Es ist aus der DE 103 11 447 A1 eine Schaltungsanordnung für ein Elektrogerät bekannt, die einen Piezo-Schalter aufweist. Der Piezo-Schalter kann unter einer Glasfläche angebracht und durch diese hindurch aktiviert werden.

Aus der US-Druckschrift US 2007/182594 A1 ist bereits ein Schaltsystem bekannt, welches elektromechanische Generatoren verwendet und Energie zu einem Aktivieren eines Kippschalters erzeugt. Die elektromechanischen Generatoren weisen elektrisch aktive Elemente oder magnetbasierte Mikrogeneratoren auf, welche zu einer Energieproduktion mechanisch aktiviert werden können. Eine dazugehörige Signalerzeugungsverschaltung kann mit einem Transmitter oder Transceiver zu einer Übermittlung und/oder zu einem Empfang von RF-Signalen an einen Empfänger oder von einem Empfänger gekoppelt sein, welcher seinerseits den Kippschalter betätigt. Innerhalb der Signalerzeugungsverschaltung kann Energie gespeichert sein, indem wiederaufladbare Batterien zu einer Energieversorgung des Transmitters oder des Transceivers verwendet werden.

Die deutsche Offenlegungsschrift DE 10 2004 035444 A1 offenbart ein Bedienelement für ein Fahrzeug. Das Bedienelement ist zu einer Bedienung einer Funktion des Fahrzeuges durch Drücken auf das Bedienelement vorgesehen. Das Bedienelement umfasst eine auf oder unter einem blattfederartigen Träger angeordnete piezoelektrische Folie.

Aus der US-Druckschrift US 3 940 637 A ist bereits eine Schlüssel-Eingabe-Vorrichtung bekannt, welche eine Schlüsselschaltung oder eine integrierte kleindimensionierte Tastatur ausbildet, die kodierte Signale mit einem hohen Signal-Rausch-Verhältnis ohne Verschlüsselungsschaltkreise erzeugt. Die Schlüssel-Eingabe-Vorrichtung umfasst eine als Drucksensor fungierende piezoelektrische Polymerschicht, auf beiden Oberflächen Schichtelektroden sowie mindestens eine Vorrichtung zum Spannen oder Dehnen der Schicht. Die Vorrichtung zum Spannen oder Dehnen definiert einen Schlüssel.

Die Aufgabe der Erfindung besteht insbesondere darin, eine gattungsgemäße Vorrichtung mit verbesserten Eigenschaften hinsichtlich einer hohen Empfindlichkeit eines Sensiervorgangs mit einem piezoelektrischen Sensorelement bereitzustellen.

Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einer Elektrogerätschaltvorrichtung mit einem Berührkörper, der einen Berührbereich zu einem Berühren bei einem Elektrogerätbedienvorgang bildet, zumindest einem piezoelektrischen Sensorelement, das dazu vorgesehen ist, eine Berührung des Berührbereichs zu erfassen, und einer Lagereinheit zum Lagern des Sensorelements.

Es wird vorgeschlagen, dass die Lagereinheit ein Lagermittel aufweist, das dazu vorgesehen ist, anhand einer Berührung des Berührbereichs eine Biegung des Sensorelements zu bewirken. Es kann hierdurch eine besonders hohe Empfindlichkeit bei einem mittels des piezoelektrischen Sensorelements durchgeführten Sensiervorgang erreicht werden. Insbesondere können mittels einer bewirkten Biegung des Sensorelements besonders geringe, auf den Berührbereich ausgeübte Kräfte erfasst werden. Unter einem "piezoelektrischen Sensorelement" soll insbesondere ein Sensorelement verstanden werden, das zur Erfassung zumindest einer Kenngröße mittels des piezoelektrischen Effekts vorgesehen ist. Insbesondere kann das Sensorelement eine elektrische Kenngröße, vorzugsweise eine elektrische Spannung, ausgeben, die von einer mechanischen Beanspruchung von zumindest einem Teilbereich des Sensorelements abhängig ist. Unter einem "Elektrogerätbedienvorgang" soll insbesondere ein Vorgang verstanden werden, den ein Bediener an einem Elektrogerät, in welchem die Elektrogerätschaltvorrichtung eingesetzt ist, vornimmt. Unter einer "Biegung" eines Bauteils soll insbesondere eine unter einer mechanischen Beanspruchung des Bauteils stattfindende Verformung des Bauteils verstanden werden, bei welcher sich - im Gegensatz zu einer unidirektionalen Kompression oder Ausdehnung des Bauteils - eine Krümmung des Bauteils bezüglich einer Erstreckungsrichtung verändert. Ferner soll unter "vorgesehen" insbesondere speziell ausgestattet und/oder ausgelegt verstanden werden.

Das Lagermittel ist als Biegeteil ausgebildet, wodurch ein besonders einfacher und kompakter Aufbau der Elektrogerätschaltvorrichtung erreicht werden kann. Unter einem "Biegeteil" soll insbesondere ein Bauteil verstanden werden, das speziell dazu ausgelegt und/oder gelagert ist, auf eine mechanische Beanspruchung des Bauteils mit einem Biegevorgang zu reagieren. Besonders vorteilhaft weist das Lagermittel federnde Eigenschaften auf, die nach Beenden einer die Biegung auslösenden mechanischen Beanspruchung des Lagermittels eine selbsttätige Rücküberführung des Lagermittels in eine Ausgangsposition ermöglichen.

Das Sensorelement ist flächenartig ausgebildet, wodurch eine hohe Empfindlichkeit bei einer Biegung des Sensorelements erreicht werden kann. Unter einem "flächenartigen" Bauteil soll insbesondere ein Bauteil verstanden werden, das eine Länge, eine Breite und eine Dicke aufweist, wobei die Dicke weniger als 10%, vorzugsweise weniger als 5% und bevorzugt weniger als 1% der Länge beträgt. Unter der "Länge" soll insbesondere die Streckenlänge des Bauteils in dessen Haupterstreckungsrichtung verstanden werden. Hierbei können die Länge und die Breite identisch ausgebildet sein.

Das Lagermittel ist flächenartig ausgebildet, wodurch vorteilhaft auswertbare Biegungsamplituden bei geringen Berührungskräften des Berührbereichs durch eine einfache Konstruktion erreicht werden können.

Ein besonders flexibles Lagermittel kann erreicht werden, wenn das Lagermittel als Blechteil ausgebildet ist.

In einer besonderen Ausführung der Erfindung wird vorgeschlagen, dass das Sensormittel am Lagermittel geklebt ist, wodurch eine besonders einfache Montage erreicht werden kann.

Eine effektive Übertragung von Berührkräften auf das Sensorelement kann einfach erreicht werden, wenn das Lagermittel mit dem Berührkörper und dem Sensorelement direkt gekoppelt ist.

In einer weiteren Ausführung der Erfindung wird vorgeschlagen, dass mittels des Lagermittels das Sensorelement in einem unberührten Zustand des Berührkörpers vorgespannt ist. Dadurch können eine besonders kurze Reaktionszeit des Sensorelements auf eine mechanische Beanspruchung des Berührungskörpers und dabei eine schnelle Erfassung einer Berührkraft erreicht werden. Dies kann besonders einfach dadurch erreicht werden, dass das Lagermittel, auf welchem das Sensorelement aufgebracht ist, in einem unberührten Zustand des Berührkörpers selbst vorgespannt ist.

Das Lagermittel ist an zumindest einem Endbereich lose abgestützt. Es kann dadurch insbesondere eine vorteilhafte Flexibilität im Einsatz der Elektrogerätschaltvorrichtung im Bezug auf Konstruktionstoleranzen erreicht werden. Dies kann besonders einfach erreicht werden, wenn der Endbereich des Lagermittels direkt am Berührkörper lose abgestützt ist. Unter einem "Endbereich" eines Bauteils soll insbesondere ein Teilbereich des Bauteils verstanden werden, welcher zumindest eine Kante des Bauteils umfasst und sich über einen Teil zumindest einer die Kante bildenden Oberfläche erstreckt, wobei der Teil maximal 10% dieser Oberfläche, vorteilhaft maximal 5% dieser Oberfläche umfasst.

In einer weiteren Ausgestaltung der Erfindung wird vorgeschlagen, dass die Elektrogerätschaltvorrichtung eine zumindest das Lagermittel umfassende Schwingungseinheit aufweist, die dazu vorgesehen ist, abhängig von einer Berührung des Berührbereichs eine Schwingung zu bewirken. Hierdurch kann eine Präzision in der Erkennung einer Berührung des Berührkörpers einfach erhöht werden. Hierzu weist das Lagermittel vorteilhafterweise Federeigenschaften auf. Besonders vorteilhaft können hohe Schwingungsamplituden erreicht werden, wenn das Lagermittel ein freies Ende aufweist.

In diesem Zusammenhang wird vorgeschlagen, dass die Schwingungseinheit eine Schwingungsmasse aufweist, die mit dem Lagermittel gekoppelt ist. Hierdurch kann eine zweckmäßige Resonanzfrequenz der Schwingungseinheit eingestellt werden. Die Schwingungsmasse ist insbesondere zusätzlich zum Lagermittel vorgesehen. Besonders vorteilhaft ist die Schwingungsmasse in einem Endbereich, insbesondere in einem freien Endbereich, des Lagermittels angeordnet.

Es wird ferner vorgeschlagen, dass die Elektrogerätschaltvorrichtung eine mit dem Sensorelement in Wirkverbindung stehende Schalteinheit aufweist, die dazu vorgesehen ist, ausgehend von einem Elektrogerätwartemodus einen Elektrogerätaktivitätsmodus abhängig von einer Berührung des Berührbereichs auszulösen. Hierdurch kann ein besonders komfortables und sicheres Einschalten eines Elektrogeräts erreicht werden.

In diesem Zusammenhang wird vorgeschlagen, dass die Schalteinheit eine Verstärkerschaltung aufweist, die dazu vorgesehen ist, ein Schaltsignal des Sensorelements zu verstärken. Hierdurch können besonders geringe Biegungswege des Sensorelements ausgewertet werden und es können dabei geringe Berührkräfte erfasst werden.

Die erfindungsgemäße Elektrogerätschaltvorrichtung eignet sich für den Einsatz bei verschiedenen Elektrogerätetypen. Besonders vorteilhaft ist jedoch der Einsatz bei einem als Kochfeld ausgebildeten Elektrogerät. Eine Kochplatte des Kochfelds ist als Berührkörper ausgebildet, wobei mittels der Lagereinheit Berührungen der Kochplatte besonders präzise erfasst werden können. Insbesondere können durch das Sensorelement Berührungen der Kochplattenoberfläche durch einen Bedienerfinger und/oder durch das Aufstellen eines Zubereitungsgeschirrs in einem Zubereitungsbereich der Kochplatte erfasst werden. In diesem Sinne kann die gesamte Kochplatte des Kochfelds die Funktion einer Bedienfläche aufweisen. Beispielsweise kann durch das Aufstellen eines Zubereitungsgeschirrs auf die Kochplatte oder durch eine Fingerberührung in einem beliebigen Bereich der Kochplatte das Kochfeld, das sich in einem Wartemodus befindet, aktiviert werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Kochfeld in einer Frontansicht mit einem Zubereitungsbereich und einem Bedienbereich,
- Fig. 2: eine Schaltvorrichtung des Kochfelds mit piezoelektrischen Senso-relementen,
- Fig. 3: eine nicht erfindungsgemäße Lagerung eines piezoelektrischen Sensorelements unterhalb des Bedienbereichs mit einem flächenartigen Lagermittel,
- Fig. 4: das Sensorelement und das Lagermittel aus Figur 3,
- Fig. 5: eine alternative Lagerung des Sensorelements in einer Schwingungseinheit,
- Fig. 6: zwei nicht erfindungsgemäße alternative Lagerungen des Sensorelements mit einem an einer Kochplatte befestigten Stützmittel, auf welchem das Lagermittel in einem Endbereich abgestützt ist,
- Fig. 7: zwei nicht erfindungsgemäße alternative Lagerungen mit dem Stützmittel, auf welchem das Lagermittel in dessen Mittelbereich abgestützt ist,
- Fig. 8: eine nicht erfindungsgemäße alternative Lagerung mit einem zwischen der Kochplatte und einer Kochfeldbodenplatte eingespannten Lagermittel und
- Fig. 9: eine nicht erfindungsgemäße alternative Lagerung von zwei Sensorelementen mit einem zwischen der Kochplatte und einer Kochfeldbodenplatte eingespannten Lagermittel.

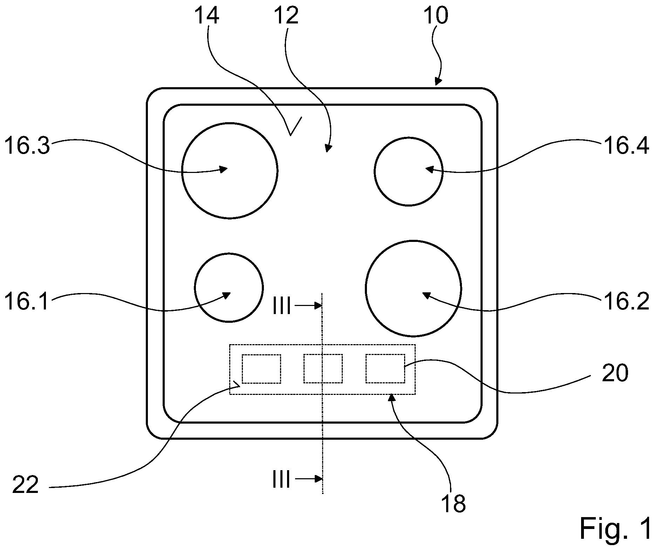

Figur 1 zeigt ein als Hausgerät ausgebildetes Elektrogerät 10 in einer Ansicht von oben. Das Elektrogerät 10 ist in diesem Beispiel als Kochfeld ausgeführt. Eine Ausführung als Backofen, Geschirrspüler, Waschmaschine usw. ist in nicht erfindungsgemäßen Ausgestaltungen ebenfalls denkbar. Das als Kochfeld ausgebildete Elektrogerät 10 weist eine Kochplatte 12 auf, die als Keramikplatte ausgebildet ist und deren Oberfläche einen Zubereitungsbereich 14 zum Auflegen von Zubereitungsgeschirren bildet. Unterhalb der Kochplatte 12 ist eine Heizeinrichtung mit Heizkörpern (nicht gezeigt) angeordnet, die einen Satz von Heizkörpern zum Heizen eines aufgelegten Zubereitungsgeschirrs aufweist. Der Zubereitungsbereich 14 ist ein zusammenhängender Bereich und weist vier Zubereitungszonen 16.1 bis 16.4 auf, die jeweils einem der Heizkörper zugeordnet und oberhalb dieses Heizkörpers angeordnet sind. Die Zubereitungszonen 16 sind mittels jeweils einer Markierung im Zubereitungsbereich 14 gekennzeichnet. Das Elektrogerät 10 weist ferner eine Elektrogerätbedienvorrichtung 18 auf, die zur Bedienung des als Kochfeld ausgebildeten Elektrogeräts 10 vorgesehen ist. Die Elektrogerätbedienvorrichtung 18 weist einen Satz von berührungsempfindlichen Bedienelementen 20 auf, die als Touch-Elemente ausgebildet sind. Die Bedienoberfläche der Elektrogerätbedienvorrichtung 18, die einen Bedienbereich 22 bildet, ist mit der Oberfläche des Zubereitungsbereichs 14 bündig ausgebildet.

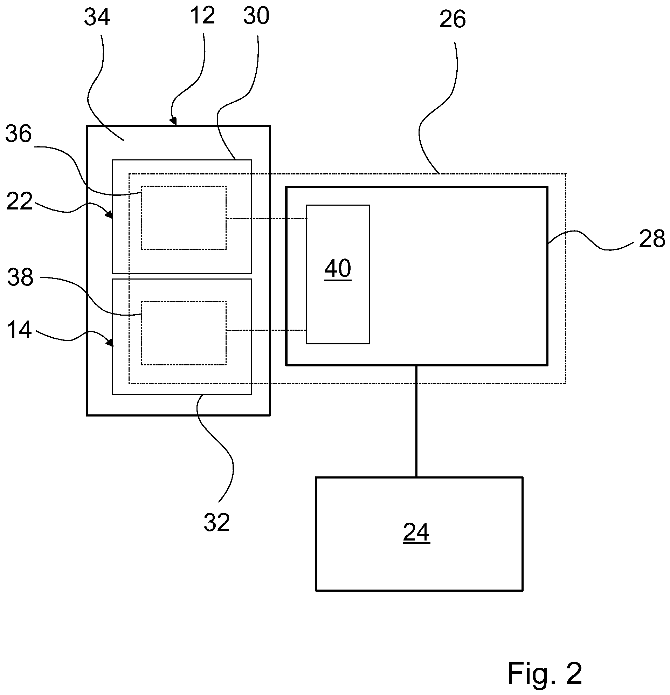

In Figur 2 ist eine Schaltung des Elektrogeräts 10 gezeigt. Es sind in einer schematischen Darstellung der Zubereitungsbereich 14 und der Bedienbereich 22 sowie eine Steuereinheit 24 abgebildet. Das Elektrogerät 10 ist mit einem Wartemodus versehen. Verbleibt das Elektrogerät 10 während einer bestimmten Zeitspanne in einem unbedienten Zustand, in dem beispielsweise die sämtlichen Heizkörper sich in einem unbetriebenen Zustand befinden, so wird von der Steuereinheit 24 der Wartemodus (oder Standby-Modus) ausgelöst, indem bestimmte Funktionsbauteile des Elektrogeräts 10 zu einer Energieersparnis ausgeschaltet werden. Zur Aktivierung des Wartemodus bzw. des Aktivitätsmodus des Elektrogeräts 10 ist die Steuereinheit 24 mit einer nicht näher dargestellten Speichereinheit, in welcher eine Datensammlung zur Ausführung dieser Modi gespeichert ist, und einer nicht näher dargestellten Recheneinheit versehen, die zur Ausführung dieser Modi anhand der Datensammlung vorgesehen ist.

Das Elektrogerät 10 weist eine Elektrogerätschaltvorrichtung 26 mit einer Schalteinheit 28 auf, die dazu dient, ausgehend von diesem Wartemodus ein Auslösen eines Aktivitätsmodus des Elektrogeräts 10 zu bewirken. Dies erfolgt in Abhängigkeit eines Berührens eines Berührbereichs 30 bzw. 32 eines Berührkörpers 34. Im betrachteten Beispiel entspricht der Berührkörper 34 der Kochplatte 12, während der Berührbereich 30, 32 dem Bedienbereich 22 bzw. dem Zubereitungsbereich 14 entspricht. Wird einer der Berührbereiche 30, 32 berührt, indem beispielsweise der Bedienbereich 22 von einem Bediener berührt wird oder ein Zubereitungsgeschirr auf den Zubereitungsbereich 14 aufgelegt wird, so übermittelt die Schalteinheit 28 ein Signal an die Steuereinheit 24, die anhand von diesem Signal ausgehend vom Wartemodus den Aktivitätsmodus auslöst, wodurch für einen Arbeitsvorgang des Elektrogeräts 10 notwendige Funktionsbauteile eingeschaltet werden. Zur Erfassung einer Berührung des Berührbereichs 30 und/oder 32 ist die Elektrogerätschaltvorrichtung 26 mit Sensorelementen versehen, die als piezoelektrische Sensorelemente 36, 38 ausgebildet sind. Das Sensorelement 36, 38 ist dem Berührbereich 30 bzw. 32 zugeordnet. Die Sensorelemente 36, 38 stehen jeweils in Wirkverbindung mit der Schalteinheit 28. Das piezoelektrische Sensorelement 36 bzw. 38 erzeugt nach einem bekannten Prinzip als Ausgangskenngröße eine elektrische Spannung, die von dessen Verformungsgrad abhängt. Diese Ausgangskenngröße, die auf die Schalteinheit 28 als Schaltsignal gegeben wird, wird mittels einer Verstärkerschaltung 40 der Schalteinheit 28 verstärkt und in der Schalteinheit 28 ausgewertet.

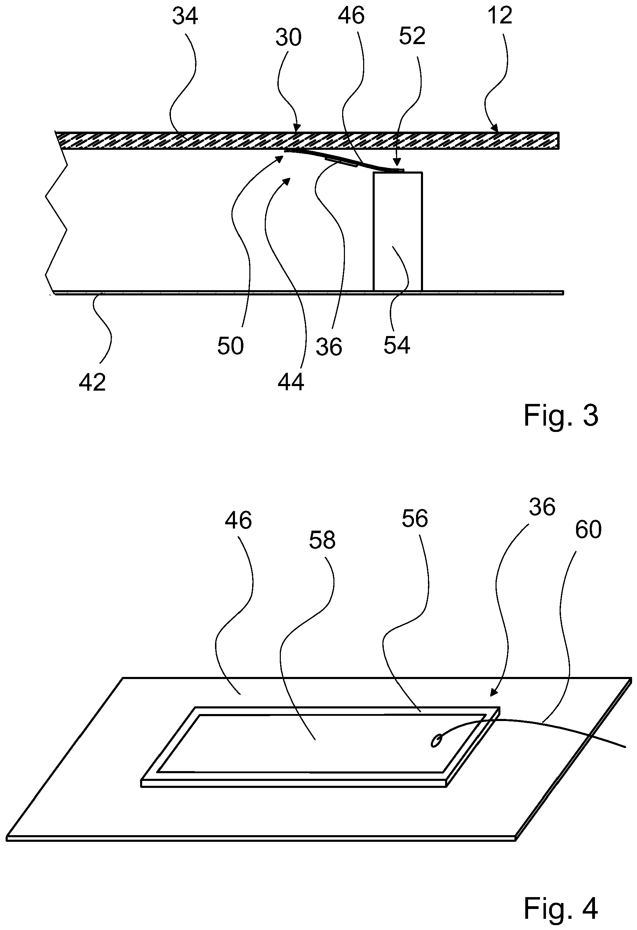

Figur 3 zeigt eine Schnittansicht eines nicht erfindungsgemäßen Elektrogeräts 10 entlang einer in Figur 1 gezeigten Schnittlinie III-III. Der Schnitt ist hierbei - wie der Figur 1 zu entnehmen ist - im Bereich der Elektrogerätbedienvorrichtung 18 durchgeführt. Es ist der Berührkörper 34 zu erkennen, welcher der Kochplatte 12 entspricht und den dem Bedienbereich 22 entsprechenden Berührbereich 30 bildet. Die Kochplatte 12 begrenzt im Zusammenwirken mit einer Bodenplatte 42 einen Elektrogerätinnenraum, in welchem insbesondere die Heizkörper, die Steuereinheit 24 und die Elektrogerätschaltvorrichtung 26 angeordnet sind. Insbesondere ist das dem Berührbereich 30 zugeordnete piezoelektrische Sensorelement 36 zu sehen. Zum Lagern des Sensorelements 36 ist die Elektrogerätschaltvorrichtung 26 mit einer Lagereinheit 44 versehen. Die Lagereinheit 44 weist ein Lagermittel 46 auf, das eine Auflagefläche bildet, auf welcher das Sensorelement 36 angeordnet ist.

Das Lagermittel 46 ist dazu vorgesehen, anhand einer Berührung des Berührbereichs 30 eine Biegung des Sensorelements 36 zu bewirken. Das Lagermittel 46 ist als Biegeteil ausgeführt, das speziell dazu ausgebildet und gelagert ist, anhand einer Berührung des Berührbereichs 30 gebogen zu werden. Um vorteilhafte Biegeeigenschaften und insbesondere große Biegeamplituden bei einer Berührung des Berührbereichs 30 zu erreichen, ist das Lagermittel 46 als ein flächenartiges Bauteil aus Blech ausgebildet. Das Sensorelement 36, das ebenfalls flächenartig ausgebildet ist, ist auf der Auflagefläche am Lagermittel 46 geklebt. Weitere, dem Fachmann als sinnvoll erscheinende Mittel zur Befestigung des Sensorelements 36 am Lagermittel 46 sind denkbar.

Das Lagermittel 46 ist mit dem Berührkörper 34 direkt gekoppelt. Hierbei liegt das Lagermittel 46 mit einem ersten Endbereich 50 an der unteren Seite der den Berührkörper 34 bildenden Kochplatte 12 an. Somit verbindet das Lagermittel 46 das Sensorelement 36 unmittelbar mit dem Berührkörper 34. Das Lagermittel 46 ist ferner in dessen Endbereich 50 gegen den Berührkörper 34 lose abgestützt. Wird aufgrund einer auf den Berührbereich 30 ausgeübten Kraft der Berührkörper 34 in Richtung auf die Bodenplatte 42 verstellt, so gleitet der Endbereich 50 des Lagermittels 46 entlang des Berührkörpers 34, und zwar entlang der Unterseite der Kochplatte 12. Ein zweiter Endbereich 52 des Lagermittels 46 ist an einem Stützmittel 54 der Lagereinheit 44 fest abgestützt. Hierbei ist der Endbereich 52 mit dem Stützmittel 54 gelötet. Dieses Stützmittel 54 ist fest mit der Bodenplatte 42 angeordnet. Insbesondere ist das Stützmittel 54 an der Bodenplatte 42 geschraubt. Somit ist der Endbereich 52 relativ zur Bodenplatte 42 unbeweglich gelagert.

Das Lagermittel 46 ist zwischen dem Berührkörper 34 und dem Stützmittel 54 vorgespannt im unberührten Zustand des Berührkörpers 34 angeordnet. Hierbei übt der Endbereich 50 des Lagermittels 46 eine Druckkraft auf den Berührkörper 34, und zwar auf die untere Seite der Kochplatte 12, aus. Durch diese Vorspannung des Lagermittels 46 ist das Sensorelement 36 ebenfalls im unberührten Zustand des Berührkörpers 34 vorgespannt. In diesem vorgespannten Zustand ist das Sensorelement 36 im unberührten Zustand des Berührkörpers 34 gebogen. Diese Vorbiegung des Lagermittels 46 und dadurch des Sensorelements 36 entsteht bei dem Zusammenbau des als Kochfeld ausgebildeten Elektrogeräts 10, indem der Berührkörper 34 bei einer Überführung in die montierte Position, in welcher der Berührkörper 34 relativ zur Bodenplatte 42 befestigt wird, das Lagermittel 46 nach unten in Richtung auf die Bodenplatte 42 drückt.

Figur 4 zeigt eine perspektivische Ansicht des Lagermittels 46 und des auf dem Lagermittel 46 aufgebrachten, insbesondere aufgeklebten Sensorelements 36. Das Lagermittel 46 und das Sensorelement 36 sind jeweils als flächenartiges Bauteil ausgebildet und bilden eine schichtförmige Anordnung, die, wie oben beschrieben, dazu vorgesehen ist, bei der Ausübung einer Druckkraft auf den Berührbereich 30 gebogen zu werden. Das Sensorelement 36 weist eine rechteckförmige Piezokeramik 56 auf. An der oberen und unteren Seite des Piezokeramik 56 ist eine als Flächenkontakt ausgebildete Schicht 58 aufgebracht. Über die untere Schicht 58 (nicht sichtbar) ist ein Flächenkontakt mit dem Lagermittel 46 hergestellt. An der Schicht 58 angebracht ist ferner ein elektrischer Anschluss 60, der eine elektrische Verbindung des Sensorelements 36 mit der Schalteinheit 28 herstellt. Der Übersichtlichkeit halber wird auf die Darstellung der elektrischen Anschlüsse in Figur 3 verzichtet. Die Form des Sensorelements 36 kann von der gezeigten rechteckigen Form abweichen. Insbesondere sind eine kreisförmige Form oder weitere, dem Fachmann als sinnvoll erscheinende Formen denkbar.

Die Lagerung des piezoelektrischen Sensorelements 38 unterhalb des dem Zubereitungsbereich 14 entsprechenden Berührbereichs 32 entspricht der oben beschriebenen Lagerung des Sensorelements 36. Es wird demnach, um Wiederholungen zu vermeiden, auf die obige Beschreibung verwiesen.

In den folgenden Figuren werden weitere Ausführungsbeispiele gezeigt, die sich in einer Lagerung des Sensorelements 36 unterscheiden. Diese Lagerungen haben mit dem obigen Ausführungsbeispiel der Figur 3 gemeinsam, dass jeweils zumindest ein Lagermittel zum Lagern des Sensorelements 36 und/oder 38 vorgesehen ist, das dazu dient, bei einer Berührung des Berührbereichs 30 und/oder 32 eine Biegung des Sensorelements 36 bzw. 38 zu bewirken. Die obige Beschreibung findet auf die folgenden Ausführungsbeispiele Anwendung, wobei sich die folgende Beschreibung - um Wiederholungen zu vermeiden - lediglich mit den Unterschieden dieser Ausführungsbeispiele zum anhand der Figur 3 beschriebenen Ausführungsbeispiel befasst. Bauteile, die im Bezug auf das Ausführungsbeispiel gemäß Figur 3 eine gleiche Funktion aufweisen, werden mit dem gleichen Bezugszeichen bezeichnet. Zum Kennzeichnen der verschiedenen Ausführungsbeispiele werden Bezugszeichen mit Buchstaben verwendet.

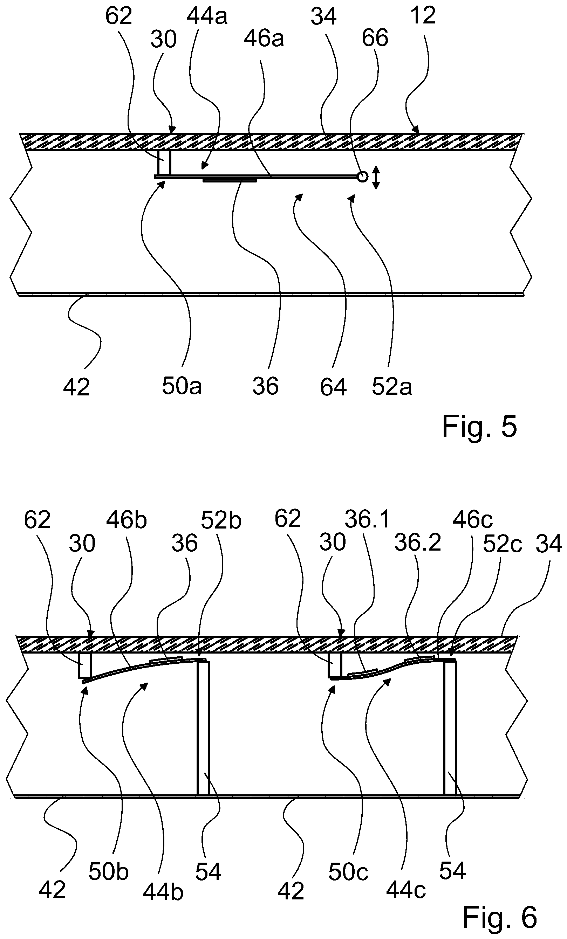

In Figur 5 ist eine Lagereinheit 44a mit einem Lagermittel 46a zu sehen, auf welchem das Sensorelement 36, wie oben beschrieben, angeordnet ist. Das Lagermittel 46a ist an einem ersten Endbereich 50a relativ zum Berührkörper 34 fest angeordnet. Hierzu ist ein Stützmittel 62 vorgesehen, an welchem der Endbereich 50a des Lagermittels 46a abgestützt ist und am Berührkörper 34, und zwar an der Unterseite der Kochplatte 12, befestigt ist. Der Endbereich 50a ist am Stützmittel 62 befestigt, wie z.B. durch eine Lötverbindung. Somit ist der Endbereich 50a des Lagermittels 46a relativ zum Berührbereich 30 unbeweglich gelagert. Das Lagermittel 46a weist einen weiteren Endbereich 52a auf, welcher als freies Ende ausgebildet ist. Hierbei ist das Lagermittel 46a Bestandteil einer Schwingungseinheit 64, die dazu vorgesehen ist, abhängig von einer Berührung des Berührbereichs 30 eine Schwingung zu bewirken. Um Schwingungsamplituden zu erreichen, die von der Schalteinheit 28 ausgewertet werden können, weist die Schwingungseinheit 64 eine Schwingungsmasse 66 auf, die mit dem Lagermittel 46a gekoppelt ist. Diese Schwingungsmasse 66 ist am freien Ende im Endbereich 52a des Lagermittels 46a fixiert. Wird eine Berührkraft auf den Berührbereich 30 ausgeübt, so werden Schwingungen der Schwingungseinheit 64 mit dem Lagermittel 46a und der Schwingungsmasse 66 angeregt. Dies bewirkt oszillierende Biegungen des Sensorelements 36 und dadurch eine oszillierende Spannung am Ausgang des Sensorelements 36, die von der Schalteinheit 28 ausgewertet werden kann.

Figur 6 zeigt weitere nicht erfindungsgemäße Ausführungsbeispiele einer Lagereinheit 44b und 44c. In der Lagereinheit 44b weist ein Lagermittel 46b einen Endbereich 50b auf, der am Stützmittel 62 abgestützt ist. Ein weiterer Endbereich 52b ist am Stützmittel 54 befestigt und ist demnach relativ zur Bodenplatte 42 unbeweglich gelagert. Der Endbereich 50b liegt am Stützmittel 62 lose an, so dass bei einer Bewegung des Berührkörpers 34 nach unten in Richtung auf die Bodenplatte 42 der Endbereich 50b des Lagermittels 46b gegen das Stützmittel 62 gleitet. In der Ausführung der Lagereinheit 44c ist das Lagermittel 46c am Stützmittel 54 sowie am Stützmittel 62 in dessen Endbereichen 50c, 52c unbeweglich befestigt. In dieser Ausführung sind auf dem Lagermittel 46c zwei Sensorelemente 36.1, 36.2 angeordnet. Diese sind jeweils in einem Biegebereich des Lagerelements 46c angeordnet, der sich an den Endbereich 50c bzw. 52c anschließt.

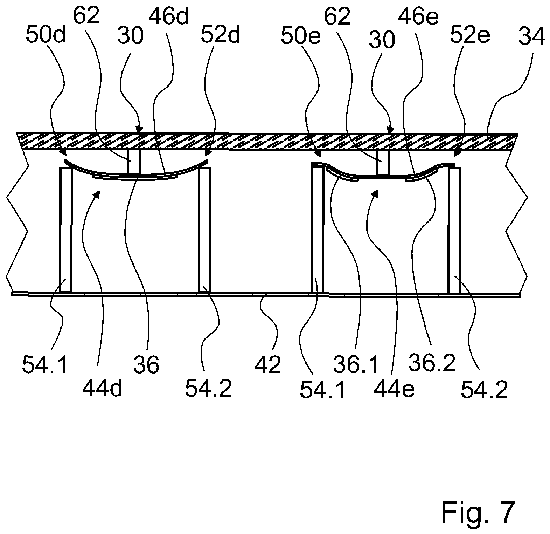

In Figur 7 sind weitere nicht erfindungsgemäße Ausführungen einer Lagereinheit 44d, 44e gezeigt. Die Lagereinheit 44d, 44e weist ein Lagermittel 46d bzw. 46e auf. Das Elektrogerät 10 weist hierbei zwei an der Bodenplatte 42 befestigte Stützmittel 54.1, 54.2 auf, die gemäß dem Stützmittel 54 in der Figur 6 aufgebaut sind. Das Lagermittel 46d bzw. 46e weist zwei Endbereiche 50d bzw. 50e und 52d bzw. 52e auf, die jeweils auf einem der Stützmittel 54.1, 54.2 abgestützt sind. Ferner ist zwischen den Endbereichen 50d bzw. 50e und 52d bzw. 52e ein Mittelbereich des Lagermittels 46d bzw. 46e nach oben in Richtung auf den Berührkörper 34 auf das Stützmittel 62 abgestützt. In der Ausführung der Lagereinheit 44d sind die Endbereiche 50d, 52d auf die Stützmittel 54.1, 54.2 lose abgestützt, so dass bei einer Berührung des Berührbereichs 30 eine Kraft über das Stützmittel 62 auf den Mittelbereich des Lagermittels 46d übertragen wird und die Endbereiche 50d, 52d gegen die Stützmittel 54.1, 54.2 gleiten. In der Ausführung der Lagereinheit 44e ist das Lagermittel 46e an beiden Endbereichen 50e, 52e mit den Stützmitteln 54.1, 54.2 befestigt. Ferner sind zwei piezoelektrische Sensorelemente 36.1 und 36.2 an dem Lagermittel 46e angebracht. Die Sensormittel 36.1, 36.2 sind an Biegestellen des Lagermittels 46e beidseitig der in dessen Mittelbereich erfolgenden Abstützung am Stützmittel 62 angeordnet.

Die Stützmittel 54, 54.1, 54.2, 62 können auf unterschiedliche Weise aufgebaut sein. In einer Alternative können diese als festes Bauteil ausgebildet sein, das keine relative Bewegung zu dem Körper zulässt, an welchem sie befestigt sind, wie insbesondere dem Berührkörper 34 oder der Bodenplatte 42. In einer weiteren Alternative ist denkbar, dass zumindest eines der Stützmittel 54, 54.1, 54.2, 62 wenigstens ein Federelement aufweist.

Dadurch können vorteilhaft mechanische Toleranzen in dem gesamten Aufbau des Elektrogeräts 10 berücksichtigt werden. Hierbei kann das Federelement als Bestandteil im Zusammenwirken mit einem weiteren festen Bestandteil das Stützmittel bilden. Der feste Bestandteil kann beispielsweise zur Führung des Federelements dienen. Ferner kann das Stützmittel vollständig als Federelement ausgebildet sein.

Die Ausführungsbeispiele der Figuren 3, 5, 6 und 7 zeigen Lagereinheiten, in welchen das jeweilige flächenartige Lagermittel eine Haupterstreckungsfläche aufweist, die im Wesentlichen parallel zur Haupterstreckungsfläche des Berührkörpers 34, und zwar insbesondere zur Oberfläche der Kochplatte 12, ausgerichtet ist. In den folgenden Figuren sind weitere nicht erfindungsgemäße Beispiele gezeigt, in welchen das jeweilige, ebenfalls flächenartig ausgebildete Lagermittel mit seiner Haupterstreckungsfläche im Wesentlichen senkrecht zur Haupterstreckungsfläche des Berührkörpers 34 ausgerichtet ist.

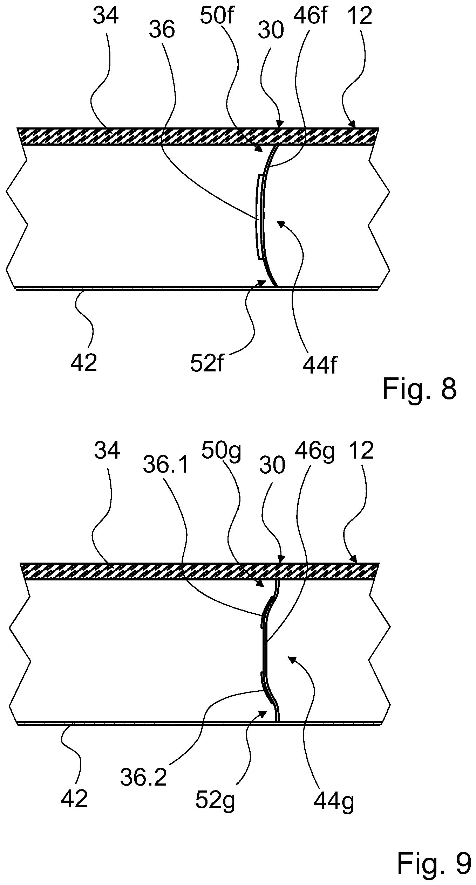

Figur 8 zeigt ein weiteres nicht erfindungsgemäßes Ausführungsbeispiel einer Lagereinheit 44f. Diese weist ein Lagermittel 46f auf, auf welchem, wie oben beschrieben, das Sensorelement 36 aufgebracht ist. Dieses Lagermittel 46f ist zwischen dem Berührkörper 34 und der Bodenplatte 42 eingespannt. Hierbei ist das Lagermittel 46f an einem ersten Endbereich 50f direkt am Berührkörper 34, und zwar an der Unterseite der Kochplatte 12, abgestützt. Das Lagermittel 46f weist einen weiteren Endbereich 52f auf, welcher sich direkt an der Bodenplatte 42 abstützt. Die Endbereiche 50f, 52f sind am Berührkörper 34 bzw. an der Bodenplatte 42 beweglich gelagert.

In Figur 9 ist eine weitere nicht erfindungsgemäße Alternative einer Lagereinheit 44g dargestellt. Diese weist ein Lagermittel 46g auf, das wie in der vorherigen Ausführung zwischen dem Berührkörper 34 und der Bodenplatte 42 eingespannt ist. Das Lagermittel 46g weist zwei Endbereiche 50g, 52g auf, die am Berührkörper 34 bzw. an der Bodenplatte 42 abgestützt sind. In der vorliegenden Ausführung sind diese Endbereiche 50g, 52g am Berührkörper 34 bzw. an der Bodenplatte 42 befestigt. Auf dem Lagermittel 46g sind zwei Sensorelemente 36.1, 36.2 aufgebracht. Diese sind jeweils in einem Biegebereich des Lagermittels 46g angeordnet, welcher sich an einen der Endbereiche 50g, 52g anschließt.

**Bezugszeichen**

| | | | |
|---|---|---|---|
| 10 | Elektrogerät | 62 | Stützmittel |
| 12 | Kochplatte | 64 | Schwingungseinheit |
| 14 | Zubereitungsbereich | 66 | Schwingungsmasse |
| 16 | Zubereitungszone | | |
| 18 | Elektrogerätbedienvorrichtung | | |
| 20 | Bedienelement | | |
| 22 | Bedienbereich | | |
| 24 | Steuereinheit | | |
| 26 | Elektrogerätschaltvorrichtung | | |
| 28 | Schalteinheit | | |
| 30 | Berührbereich | | |
| 32 | Berührbereich | | |
| 34 | Berührkörper | | |
| 36 | piezoelektrisches Sensorelement | | |
| 38 | piezoelektrisches Sensorelement | | |
| 40 | Verstärkerschaltung | | |
| 42 | Bodenplatte | | |
| 44 | Lagereinheit | | |
| 46 | Lagermittel | | |
| 50 | Endbereich | | |
| 52 | Endbereich | | |
| 54 | Stützmittel | | |
| 56 | Piezokeramik | | |
| 58 | Flächenkontakt | | |
| 60 | Anschluss | | |

## Patentansprüche

1. Kochfeld mit einer Kochplatte (12) und mit einer Elektrogerätschaltvorrichtung mit einem Berührkörper (34), der einen Berührbereich (30, 32) zu einem Berühren bei einem Elektrogerätbedienvorgang bildet, zumindest einem piezoelektrischen Sensorelement (36, 38), das dazu vorgesehen ist, eine Berührung des Berührbereichs (30, 32) zu erfassen, und einer Lagereinheit (44; 44a-g) zum Lagern des Sensorelements, wobei die Kochplatte (12) als der Berührkörper (34) ausgebildet ist, wobei die Lagereinheit (44; 44a-g) ein Lagermittel (46; 46a-g) aufweist, das dazu vorgesehen ist, anhand einer Berührung des Berührbereichs (30, 32) eine Biegung des Sensorelements (36, 38) zu bewirken, wobei das Lagermittel (46; 46a-g) flächenartig ausgebildet ist, wobei das Lagermittel (46) eine Auflagefläche bildet, auf welcher das Sensorelement (36) angeordnet ist, wobei das Lagermittel (46; 46a-g) als Biegeteil ausgebildet ist, wobei das Sensorelement (36, 38) flächenartig ausgebildet ist, wobei das Sensorelement (36) auf der Auflagefläche am Lagermittel (46) aufgebracht ist, **dadurch gekennzeichnet, dass** das Lagermittel (46; 46b; 46d; 46f) an zumindest einem Endbereich (50; 50b; 50d, 52d; 50f, 52f) lose abgestützt ist.

2. Kochfeld nach Anspruch 1, **dadurch gekennzeichnet, dass** das Lagermittel (46; 46a-g) als Blechteil ausgebildet ist.

3. Kochfeld nach Anspruch 1 oder 2, **dadurch gekennzeichnet, dass** das Sensormittel (36, 38) am Lagermittel (46; 46a-g) geklebt ist.

4. Kochfeld nach einem der vorhergehenden Ansprüche, **dadurch gekennzeichnet, dass** das Lagermittel (46; 46f; 46g) mit dem Berührkörper (34) und dem Sensorelement (36, 38) direkt gekoppelt ist.

5. Kochfeld nach einem der vorhergehenden Ansprüche, **dadurch gekennzeichnet, dass** mittels des Lagermittels (46; 46a-g) das Sensorelement (36, 38) in einem unberührten Zustand des Berührkörpers (34) vorgespannt ist.

6. Kochfeld nach einem der vorhergehenden Ansprüche, **dadurch gekennzeichnet, dass** die Elektrogerätschaltvorrichtung eine zumindest das Lagermittel (46b) umfassende Schwingungseinheit (64) aufweist, die dazu vorgesehen ist, abhängig von einer Berührung des Berührbereichs (30, 32) eine Schwingung zu bewirken.

7. Kochfeld nach Anspruch 6, **dadurch gekennzeichnet, dass** die Schwingungseinheit (64) eine Schwingungsmasse (66) aufweist, die mit dem Lagermittel (46b) gekoppelt ist.

8. Kochfeld nach einem der vorhergehenden Ansprüche, **dadurch gekennzeichnet, dass** die Elektrogerätschaltvorrichtung eine mit dem Sensorelement (36, 38) in Wirkverbindung stehende Schalteinheit (28) aufweist, die dazu vorgesehen ist, ausgehend von einem Elektrogerätwartemodus einen Elektrogerätaktivitätsmodus abhängig von einer Berührung des Berührbereichs (30, 32) auszulösen.

9. Kochfeld nach Anspruch 8, **dadurch gekennzeichnet, dass** die Schalteinheit (28) eine Verstärkerschaltung (40) aufweist, die dazu vorgesehen ist, ein Schaltsignal des Sensorelements (36, 38) zu verstärken.

## Claims

1. Hob with a hotplate (12) and with an electric appliance switching device with a touch element (34), which forms a touch region (30, 32) for touching during an electric appliance operating procedure, at least one piezoelectric sensor element (36, 38), which is provided to capture a touching of the touch region (30, 32), and a bearing unit (44; 44a-g) for mounting the sensor element, wherein the hotplate (12) is embodied as the touch element (34), wherein the bearing unit (44; 44a-g) has a bearing means (46; 46a-g), which is provided to cause the sensor element (36, 38) to bend on the basis of a touching of the touch region (30, 32), wherein the bearing means (46; 46a-g) is embodied in an area-like manner, wherein the bearing means (46) forms a contact area, on which the sensor element (36) is arranged, wherein the bearing means (46; 46a-g) is embodied as a bending part, wherein the sensor element (36, 38) is embodied in an area-like manner, wherein the sensor element (36) is attached to the contact area on the bearing means (46), **characterised in that** the bearing means (46; 46b; 46d; 46f) is loosely supported against at least one end region (50; 50b; 50d, 52d; 50f; 52f).

2. Hob according to claim 1, **characterised in that** the bearing means (46; 46a-g) is embodied as a sheet metal part.

3. Hob according to claim 1 or 2, **characterised in that** the sensor means (36, 38) is adhesively bonded to the bearing means (46; 46a-g).

4. Hob according to one of the preceding claims, **characterised in that** the bearing means (46; 46f; 46g) is directly coupled to the touch element (34) and the sensor element (36, 38).

5. Hob according to one of the preceding claims, **characterised in that** the sensor element (36, 38) is pretensioned by means of the bearing means (46; 46a-g) in an untouched state of the touch element (34).

6. Hob according to one of the preceding claims, **characterised in that** the electric appliance switching device has an oscillation unit (64) at least including the bearing means (46b), which is provided to cause an oscillation as a function of a touching of the touch region (30, 32).

7. Hob according to claim 6, **characterised in that** the oscillation unit (64) has an oscillation mass (66) which is coupled to the bearing means (46b).

8. Hob according to one of the preceding claims, **characterised in that** the electric appliance switching device has a switch unit (28) actively connected to the sensor element (36, 38), which is provided, starting from an electric appliance wait mode, to trigger an electric appliance activity mode as a function of a touching of the touch region (30, 32).

9. Hob according to claim 8, **characterised in that** the switch unit (28) has an amplifier circuit (40), which is provided to amplify a switching signal of the sensor element (36, 38).

## Revendications

1. Plan de cuisson comportant une plaque de cuisson (12) et un dispositif de coupure de courant d'appareil électroménager avec un corps de contact (34) qui forme une zone de contact (30, 32) pour un contact lors d'une utilisation de l'appareil électroménager, au moins un élément de détection piézoélectrique (36, 38) qui est prévu pour capter un contact de la zone de contact (30, 32), et une unité de dépôt (44 ; 44a-g) destinée au dépôt de l'élément de détection, dans lequel la plaque de cuisson (12) est réalisée en tant que corps de contact (34), dans lequel l'unité de dépôt (44 ; 44a-g) présente un moyen de dépôt (46 ; 46a-g) qui est prévu pour exercer une flexion de l'élément de détection (36, 38) à l'aide d'un contact de la zone de contact (30, 32), dans lequel l'élément de dépôt (46 ; 46a-g) est réalisé de manière plane, dans lequel l'élément de dépôt (46) forme une surface de support sur laquelle l'élément de détection (36) est disposé, dans lequel le moyen de dépôt (46 ; 46a-g) est réalisé en tant que pièce flexible, dans lequel l'élément de détection (36, 38) est réalisé de manière plane, dans lequel l'élément de détection (36) est appliqué sur la surface de support au niveau du moyen de dépôt (46), **caractérisé en ce que** le moyen de dépôt (46 ; 46b ; 46d ; 46f) prend appui de manière lâche au niveau d'au moins une zone d'extrémité (50 ; 50b ; 50d, 52d ; 50f, 52f).

2. Plan de cuisson selon la revendication 1, **caractérisé en ce que** le moyen de dépôt (46 ; 46a-g) est réalisé en tant que pièce en tôle.

3. Plan de cuisson selon la revendication 1 ou 2, **caractérisé en ce que** le moyen de détection (36, 38) est collé au niveau du moyen de dépôt (46 ; 46a-g).

4. Plan de cuisson selon l'une des revendications précédentes, **caractérisé en ce que** le moyen de dépôt (46 ; 46f, 46g) est couplé directement avec le corps de contact (34) et l'élément de détection (36, 38).

5. Plan de cuisson selon l'une des revendications précédentes, **caractérisé en ce que,** au moyen du moyen de dépôt (46 ; 46a-g), l'élément de détection (36, 38) est précontraint dans un état non mis en contact du corps de contact (34).

6. Plan de cuisson selon l'une quelconque des revendications précédentes, **caractérisé en ce que** le dispositif de coupure de courant d'appareil électroménager présente au moins une unité vibrante (64) comprenant le moyen de dépôt (46b), laquelle unité vibrante est prévue pour exercer une vibration en fonction d'un contact de la zone de contact (30, 32).

7. Plan de cuisson selon la revendication 6, **caractérisé en ce que** l'unité vibrante (64) présente une masse vibrante (66) qui est couplée avec le moyen de dépôt (46b).

8. Plan de cuisson selon l'une des revendications précédentes, **caractérisé en ce que** le dispositif de coupure de courant d'appareil électroménager présente une unité de coupure de courant (28) en coopération avec l'élément de détection (36, 38), laquelle unité de coupure de courant est prévue pour déclencher un mode d'activité d'appareil électroménager en fonction d'un contact de la zone de contact (30, 32) en partant d'un mode d'attente d'appareil électroménager.

9. Plan de cuisson selon la revendication 8, **caractérisé en ce que** l'unité de coupure de courant (28) présente un circuit amplificateur (40) qui est prévu pour amplifier un signal de coupure de courant de l'élément de détection (36, 38).
